# EUROPEAN PATENT APPLICATION

(11) **EP 1 921 459 A1**
(43) Date of publication of application: **14.05.2008**
(21) Application number: 06796585.5
(22) Date of filing: 21.08.2006
(51) Int. Cl.: G01R 31/28, G01R 31/26, G01R 35/00

(54) **CALIBRATION BOARD FOR ELECTRONIC COMPONENT TESTING APPARATUS**

(30) Priority: 31.08.2005 JP 2005252602
(71) Applicant: ADVANTEST CORPORATION, Tokyo 179-0071 (JP)
(72) Inventor: TAKAKI, Shintaro, Isehara-shi, Kanagawa 179-0071 (JP); HAMA, Hiroyuki, Nerima-ku, Tokyo 179-0071 (JP); SAKIYAMA, Shin, Nerima-ku, Tokyo 179-0071 (JP); MATSUMURA, Shigeru, Nerima-ku, Tokyo 179-0071 (JP)
(74) Representative: Wiebusch, Manfred
(86) International application number: PCT/JP2006/316322
(87) International publication number: WO 2007/026563

(57) **Abstract**

A calibration board 80A mounted on a socket 50 when calibrating an electronic device test apparatus for testing an IC by bringing ball contacts of the IC into electrical contact with contact terminals 70 of the socket 50, comprises; calibration terminals 81 for electrically contacting the contact terminals 70; and a board 86 comprising an insulating member and provided with the calibration terminals 81, wherein the calibration terminals 81 have spherical members 85 sticking out from the board 86 toward the contact terminals 70 so as to correspond to the shapes of the contact terminals 70.

## Description

### TECHNICAL FIELD

The present invention relates to a calibration board for an electronic device test apparatus mounted on contact terminals of a socket when calibrating an electronic device test apparatus for testing semiconductor integrated circuit devices and other various types of electronic devices (hereinafter also referred to representatively as "Ics").

### BACKGROUND ART

In an electronic device test apparatus, a handler is used to transport a large number of ICs, the ICs are brought into electrical contact with contact terminals of sockets mounted at a test head, and the main body of the electronic device test apparatus, that is, a tester, is used to simultaneously test the ICs.

Such an electronic device test apparatus is calibrated to maintain the test precision at a certain level. In this calibration of an electronic device test apparatus, a calibration board dedicated to calibration is mounted on the test head, a probe is brought into contact with predetermined measurement positions of this calibration board, and the signals output to an oscilloscope etc. connected to said probe are adjusted so as to calibrate the electronic device test apparatus.

As such a calibration technique, the method of detaching a socket from the test head and mounting the calibration board on the socket board, and the method of mounting the calibration board on the socket in that state leaving the socket mounted on the test head and bringing pads formed on the lower surface of the calibration board into electrical contact with the contact terminals of the socket (so-called "HI-CAL" method) are known. With the latter method, it is possible to calibrate the electronic device test apparatus in the state closest to an actual test.

On the other hand, as a socket for stabilizing the contact between the IC input/output terminals and contact terminals and keeping down damage to the IC input/output terminals, one comprises a housing at which through holes having diameters larger than the IC input/output terminals are provided, and contact terminals provided at said through holes and contacting side parts of the corresponding input/output terminals has been known in the past (forexample, see Patent Publication 1).

In such a socket, the contact terminals are completely retracted in the housing, so the pads of a calibration board cannot be made to contact said contact terminals and therefore the electronic device test apparatus cannot be calibrated in the state with the socket mounted.

Patent Publication 1: International Publication No. WO2005/011069 Pamphlet

### DISCLOSURE OF THE INVENTION

The present invention has as its object the provision of a calibration board enabling calibration of an electronic device test apparatus mounting a socket of a type where the contact terminals are retracted in the housing.

Toachievetheaboveobject, according to the present invention, there is provided a calibration board mounted on a socket when calibrating an electronic device test apparatus for testing an electronic device under test by bringing input/output terminals of the electronic device under test into electrical contact with contact terminals of the socket, comprising: calibration terminals for electrically contacting said contact terminals; and a board comprising an insulating member and provided with the calibration terminals, wherein the calibration terminals have projections sticking out from the board toward the contact terminal sides so as to correspond to the shapes of the contact terminals (see claim 1).

In the present invention, projections sticking out from the board toward the contact terminal sides so as to correspond to the shapes of the contact terminals are provided at the calibration terminals. At the time of calibration, the projections enter into the housing and electrically contact the contact terminals, so calibration of an electronic device test apparatus mounting a socket of a type where contact terminals are recessed in the housing becomes possible.

While not particularly limited in the above invention, the projections of the calibration terminals preferably have curved surface shapes (see claim 2). Due to this, it is possible to shave off any solder transferred to the front ends of the contact terminals at the time of a test by the curved surfaces at the time of calibration, so it is possible to stably connect the calibration terminals and contact terminals.

To achieve the above object, according to the present invention, there is provided a calibration board mounted on contact terminals of a socket when calibrating an electronic device test apparatus for testing an electronic device under test by bringing input/output terminals of the electronic device under test into electrical contact with the contact terminals, comprising: calibration terminals electrically contacting said contact terminals; and a board comprising an insulating member and provided with the calibration terminals, wherein the calibration terminals have projections sticking out from the board toward the contact terminal sides in a curved surface shape (see claim 3).

By providing projections sticking out from the board toward the contact terminals at the calibration terminals, calibration of an electronic device test apparatus mounting a socket of a type where the contact terminals are retracted in the housing becomes possible. Further, by making the projections curved surfaces, it is possible to shave off any solder transferred to the front ends of the contact terminals at the time of a test by the curved surfaces at the time of calibration, so it is possible to stably connect the calibration terminals and contact terminals. Further, even when used for a type where the contact terminals are not recessed in the housing (for example, an ordinary pogo pin type), any solder transferred to the front ends of the contact terminals can be shaved off by the curved surfaces.

While not particularly limited in the above invention, preferably a plurality of the calibration terminals are provided on the board in substantially the same array as an array of the contact terminals of the socket (see claim 4).

While not particularly limited in the above invention, the projections are preferably conductive spherical members bonded to pads provided on the board (see claim 5).

While not particularly limited in the above invention, preferably the calibration terminals are conductive pins provided so as to pass through the board and the projections are curved surface parts formed at the front ends of the pins and sticking out from the board toward the contact terminals (see claim 6).

### BRIEF DESCRIPTION OF THE DRAWINGS

[FIG. 1] FIG. 1 is a block diagram showing the configuration of an electronic device test apparatus according to an embodiment of the present invention.
[FIG. 2] FIG. 2 is a perspective view of a socket used for the electronic device test apparatus shown in FIG. 1.
[FIG. 3] FIG. 3 is a cross-sectional view of a socket along the line III-III of FIG. 2.
[FIG. 4] FIG. 4 is an enlarged plan view of a through hole and contact terminal when viewing the socket shown in FIG. 2 from the housing surface side.
[FIG. 5] FIG. 5 is a cross-sectional view of a contact terminal used for the socket shown in FIG. 2.
[FIG. 6] FIG. 6 is a perspective view of a contact terminal used for a socket shown in FIG. 2.
[FIG. 7] FIG. 7 is a cross-sectional view of a socket in the state where a ball contact of an IC contacts a contact terminal.
[FIG. 8] FIG. 8 is a perspective view showing a calibration board according to a first embodiment of the present invention as seen from the surface of the side facing the socket.
[FIG. 9] FIG. 9 is a cross-sectional view along the line IX-IX of FIG. 8.
[FIG. 10] FIG. 10 is a plan view showing a plurality of calibration boards held in a frame.
[FIG. 11] FIG. 11 is a view showing the state of using a calibration board according to a first embodiment of the present invention to calibrate an electronic device test apparatus.
[FIG. 12] FIG. 12 is a cross-sectional view showing a calibration board according to a second embodiment of the present invention.
[FIG. 13] FIG. 13 is a cross-sectional view showing a calibration board according to a third embodiment of the present invention.

### DESCRIPTION OF NOTATIONS

1... electronic device test apparatus
10... pattern generator
20... waveform shaper
30... judgment unit
40... socket board
50... socket
60... housing
62... through hole
70... contact terminal
80A to 80C... calibration boards
81... calibration terminal
82... upper surface pad
83... lower surface pad
84... through hole
85... spherical member
85a... side part
86... board
86a... insertion hole
87... pin
87a... front end part
87b... step part
88... pin
88a... front end part
88b... step part
100... IC
110... ball contact
200... oscilloscope
210... probe

### BEST MODE FOR CARRYING OUT THE INVENTION

Below, embodiments of the present invention will be explained based on the drawings.

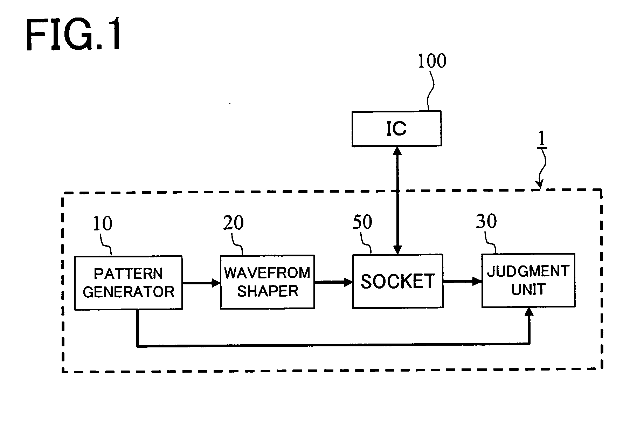

FIG. 1 is a block diagram showing the configuration of an electronic device test apparatus in an embodiment of the present invention.

Before explaining a calibration board according to this embodiment, an electronic device test apparatus to which said calibration board is applied and mounting sockets with contact terminals recessed in housings will be explained in brief.

An electronic device test apparatus 1 is an apparatus for testing ICs 100 comprising BGA units having a plurality of ball contacts 110. As shown in FIG. 1, it is provided with a pattern generator 10, a waveform shaper 20, a socket 50, and a judgment unit 30.

The pattern generator 10 for example generates a test pattern to be stored in a semiconductor memory or other IC 100 and supplies said test pattern through the waveform shaper 20 and socket 50 to the IC 100. Further, the pattern generator 10 generates an expected value signal which the IC 100 should output in accordance with the generated test pattern and supplies this to the judgment unit 30.

The waveform shaper 20 shapes the test pattern and supplies it at a predetermined timing to the socket 50. The socket 50 is electrically connected to the IC 100 and transfer signals with the IC 100. Further, the socket 50 is connected through a socket board 40 to the waveform shaper 20 and judgment unit 30. The socket board 40 actually has a number of sockets 50 corresponding to the number of simultaneous measurements (for example, 32 sockets arranged in four rows and eight columns) mounted on it and is designed to enable signals to be transferred in parallel with a plurality of ICs 100.

The judgment unit 30 receives an output signal output by the IC 100 in accordance with the test pattern through the socket 50 and judges the quality of the IC 100 based on the results of comparison of the output signal and the expected value signal.

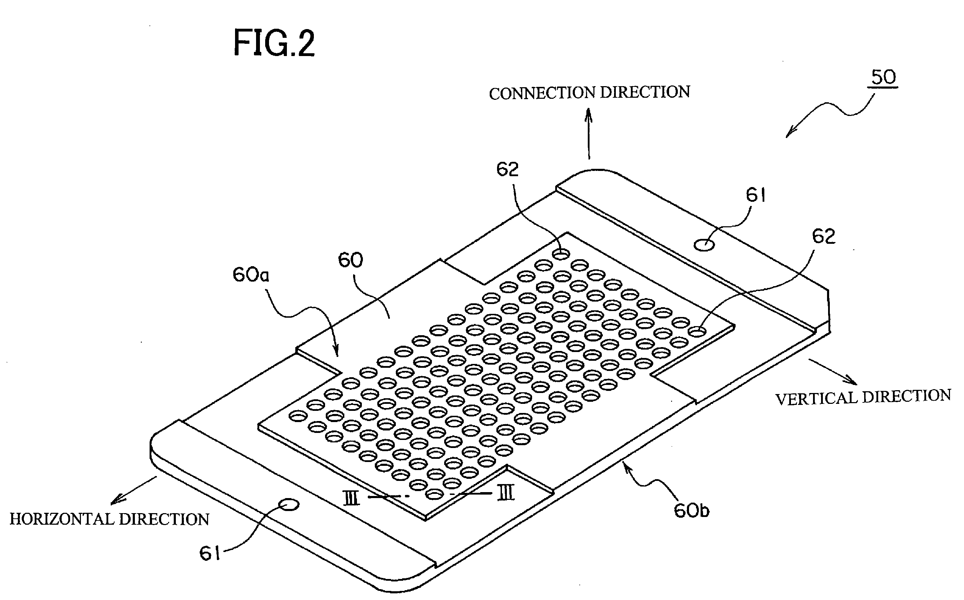

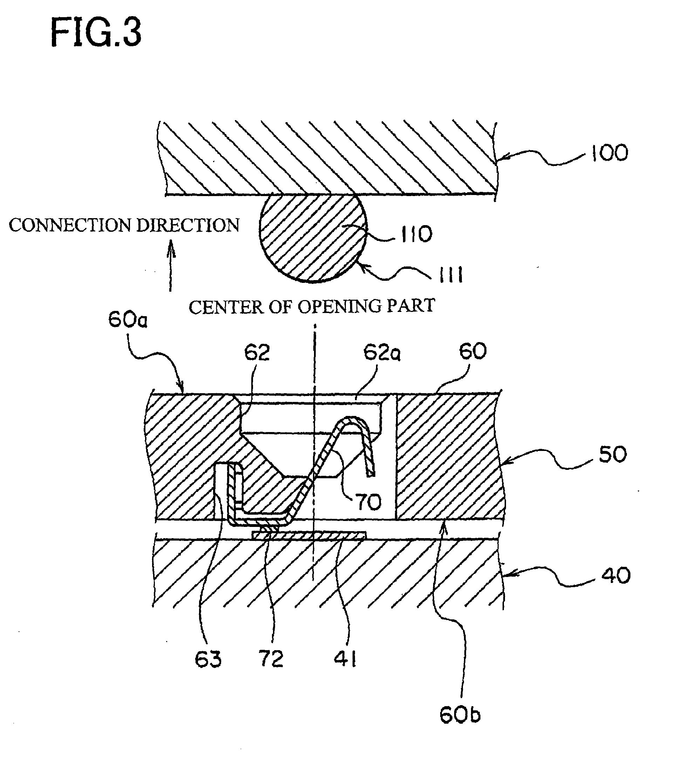

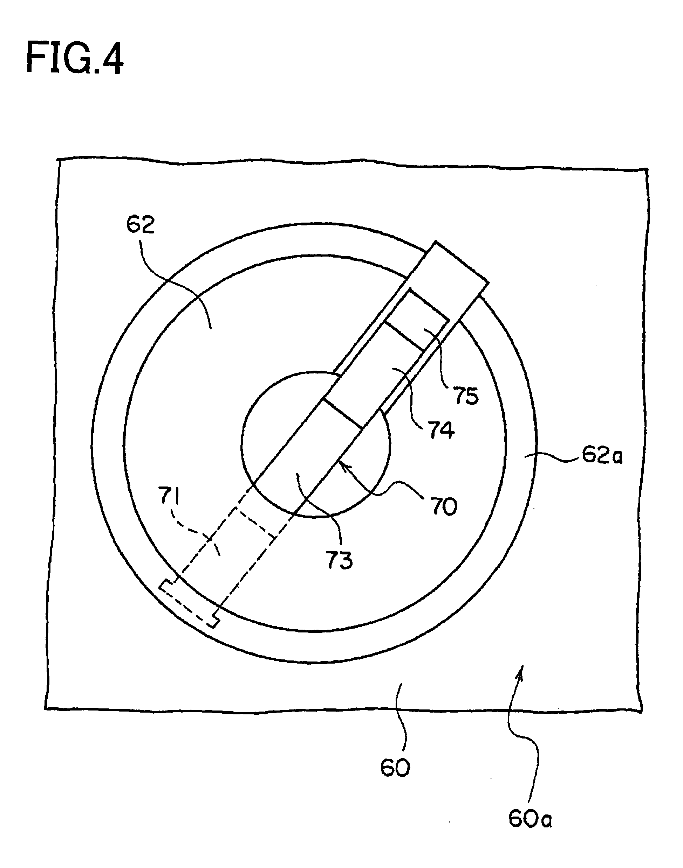

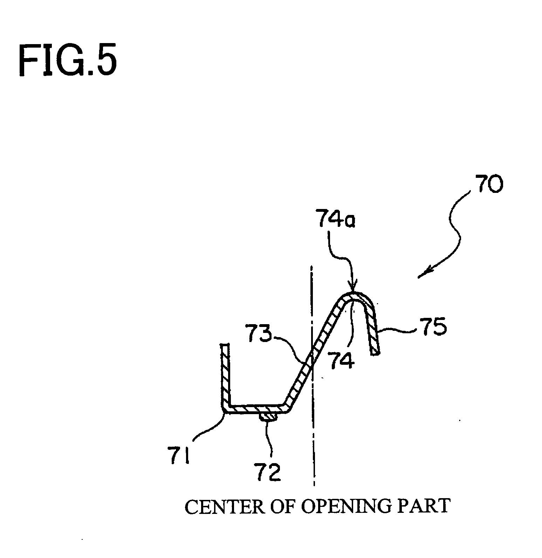

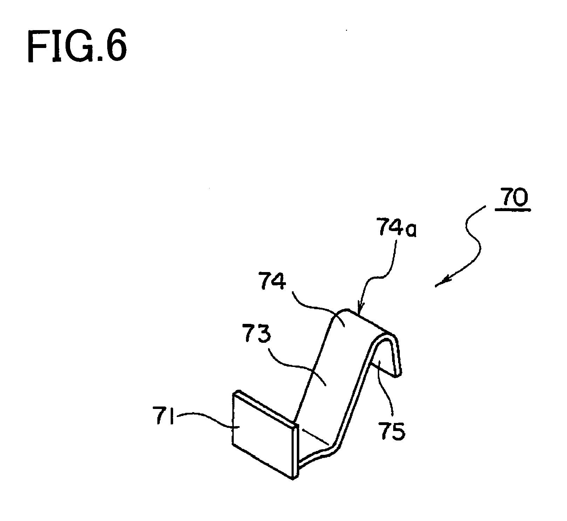

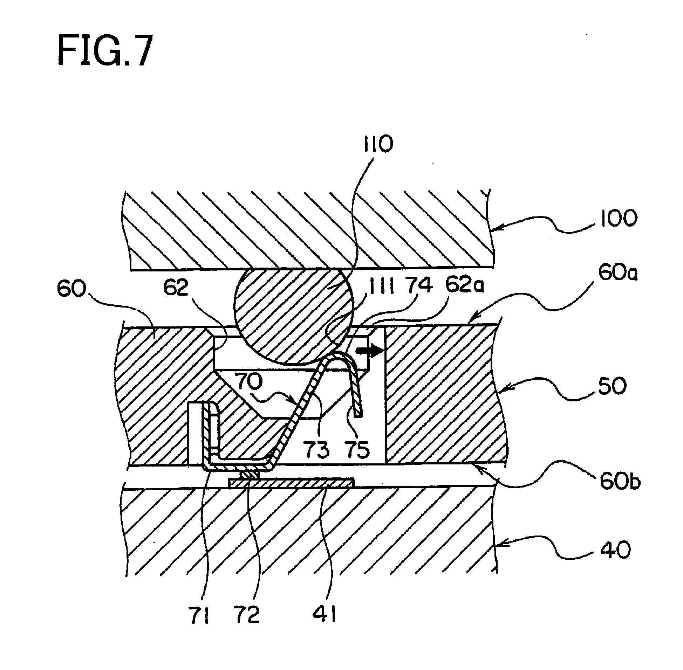

FIG. 2 is a perspective view of a socket used for the electronic device test apparatus shown in FIG. 1, FIG. 3 is a cross-sectional view along the line III-III of FIG. 2, FIG. 4 is an enlarged plan view of a through hole and contact terminal when viewing the socket shown in FIG. 2 from the housing surface side, FIG. 5 and FIG. 6 are a cross-sectional view and a perspective view of a contact terminal used for the socket shown in FIG. 2, and FIG. 7 is a cross-sectional view of a socket in the state where a ball contact of an IC contacts a contact terminal.

A socket 50, as shown in FIG. 2 to FIG. 4, has a housing 60 formed with a plurality of through holes 62 and a plurality of contact terminals 70 for electrically contacting ball contacts 110 of an IC 100.

At the surface of the housing 60 at the side facing the BGA unit, a plurality of through holes 62 are formed so as to correspond to the plurality of ball contacts 110 forming the BGA unit. Further, at the both side parts of the housing 60, fastening holes 61 are formed for mounting the socket 50 on the socket board 40.

Each through hole 62, as shown in FIG. 3 and FIG. 4, has a circular opening part which opens to the surface 60a of the housing 60 and comprises a substantially conical shape hole of a predetermined depth from the surface 60a of the housing 60 and a substantially columnar hole provided extending from said columnar hole.

The opening part of each through hole 62 has a diameter larger than the diameter of a ball contact 110. Part of the ball contact 110 can therefore enter the substantially conical shaped hole in the through hole 62.

Further, the entire peripheral edge of the opening part of each through hole 62 is chamfered so as to form a chamfered part 62a. Due to this, even when a ball contact 110 is pushed in a state offset from the through hole 62, the ball contact 110 will be reliably guided by the chamfered part 62a into the through hole 62, so it becomes possible to reduce damage to the ball contact 110.

A plurality of through holes 62 of this configuration, as shown in FIG. 2, are arranged in the housing 60 at predetermined intervals along the vertical direction and horizontal direction.

The housing 60 is for example made from a plastic material or other insulating material. For this reason, when contact terminals 70 are provided in the through holes 62, the contact terminals 70 can be electrically insulated from each other. As the plastic material forming the housing 60, for example, a glass epoxy resin etc. may be mentioned.

The contact terminals 70 are provided inside the plurality of through holes 62 formed in the housing 60. The contact terminals 70 contact the ball contacts 110 forming the BGA unit, whereby the IC 100 and the socket 50 are electrically connected.

Each contact terminal 70, as shown in FIG. 5 and FIG. 6, has a fastening part 71, a ball side contact 72, an elastic part 73, a curved surface part 74, and a terminating part 75.

The fastening part 71 is fastened to the rear surface 60b of the housing 60 whereby the contact terminal 70 is fixed in position. For example, the rear surface 60d of the housing 60, as shown in FIG. 3, is provided with an engagement groove 63 for engagement with the fastening part 71. By press-fitting part of the fastening part 71 into this engagement groove 63, the contact terminal 70 is fixed with respect to the housing 60.

The curved surface part 74 has a curved surface contacting the side part 111 of the ball contact 110. The curved surface part 74, for example, is a shape obtained by bending one end of a flat conductive plate. The curved surface part 74 has a vertex 74a oriented in the direction from the housing 60 to the IC 100. As shown in FIG. 4, the contact terminal 70 is provided at the through hole 62 so that this vertex 74a is positioned at the peripheral edge side from the center of the opening part of the through hole 62. As opposed to this, the position of the fastening part 71 in the plane parallel to the surface 60a of the housing 60 is the opposite side from the vertex 74a of the curved surface part across the opening part. Further, as shown in FIG. 3, the height of the vertex 74a of the curved surface part 74 in the direction oriented from the housing 60 to the IC 100 is lower than the surface 60a of the housing 60. As a result, the contact terminal 70 is completely recessed in the housing 60.

The elastic part 73 is provided so as to extend from the fastening part 71 to the curved surface part 74. This elastic part 73 is formed by an elastic member having elastic recovery force. This elastic part 73 elastically deforms in accordance with the pushing force applied from the ball contact 110 to the curved surface part 74, whereby the curved surface part 74 can be made to move in the radial direction of the opening part.

The terminating part 75 is provided extending from the curved surface part 74. Further, a board side contact 72 sticking out toward the socket board 40 side is provided at the fastening part 51. This board side contact 72 is provided in a region substantially parallel to the rear surface 60b of the housing 60 in the fastening part 71. The board side contact 72 contacts the terminal 41 of the socket board 40, whereby the socket 50 and the socket board 40 are electrically connected.

When using a socket 50 configured in the above way to test an IC 100, as shown in FIG. 7, first, the ball contact 110 of the IC 100 enters the through hole 62. Next, said ball contact 110 pushes the curved surface part 74 of the contact terminal 70, whereupon the elastic part 73 makes the curved surface part 74 move in accordance with said pushing force and the side part 111 of the ball contact 110 slides over and contacts the curved surface part 74.

When the ball contact 110 and the contact terminal 70 contact each other, the side part 111 of the ball contact 110 slides over the curved surface part 74, so any oxide film etc. formed on the surface of the ball contact 110 is removed and the reliability of the connection between the ball contact 110 and the contact terminal 70 can be improved.

Further, when the ball contact 110 and the contact terminal 70 contact, the ball contact 110 is made to slide on the curved surface part 74, whereby it is possible to suppress damage to the ball contact 110 accompanying contact.

Next, a calibration board according to an embodiment of the present invention will be explained.

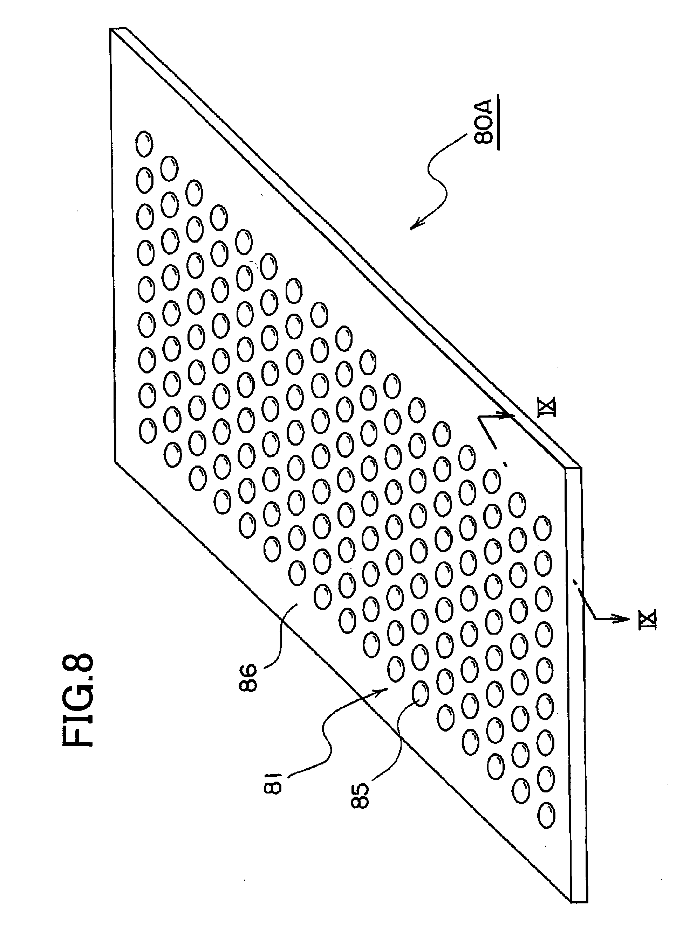

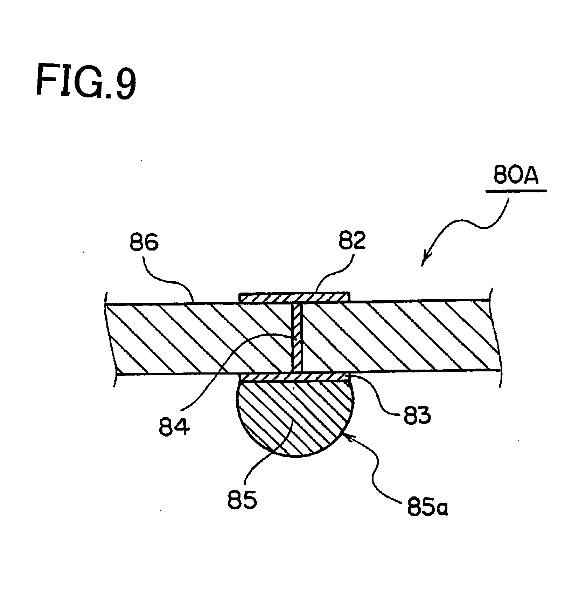

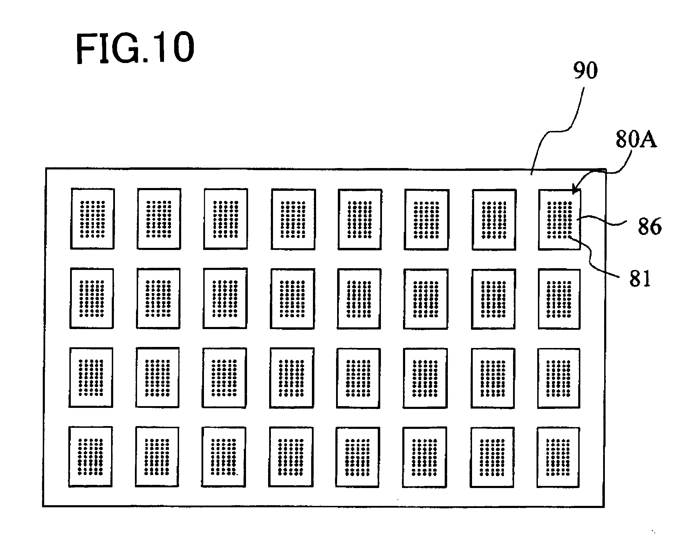

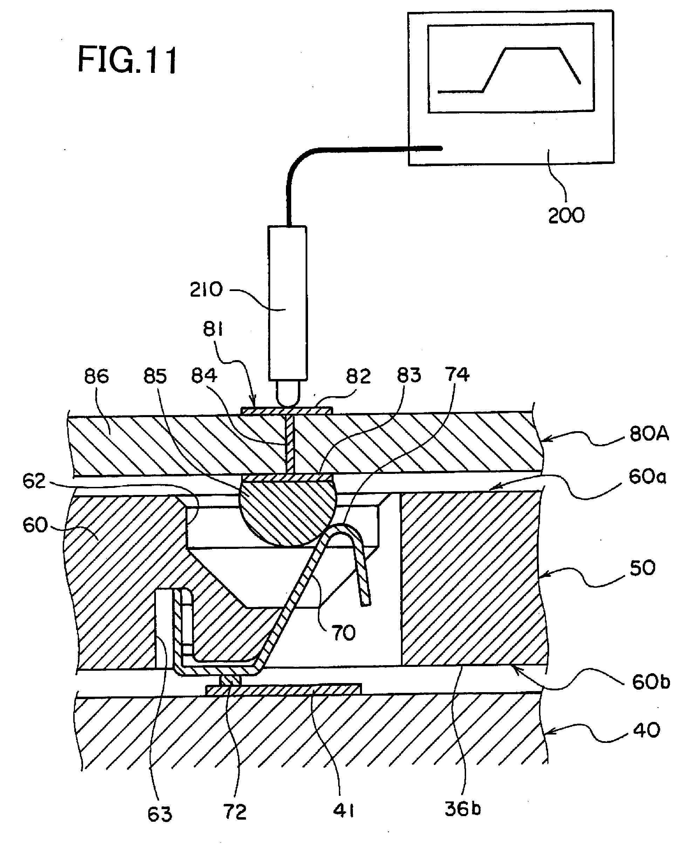

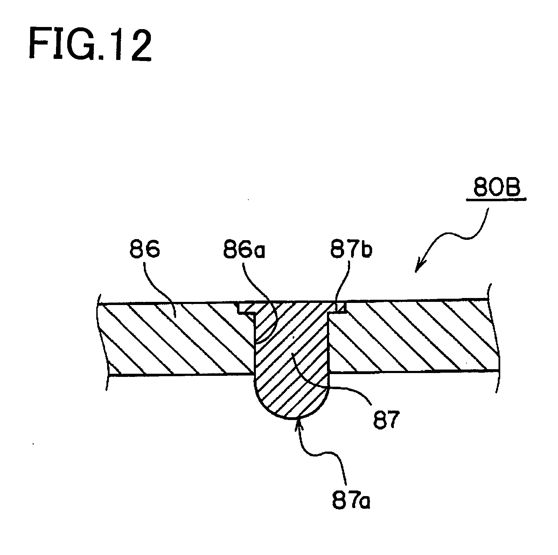

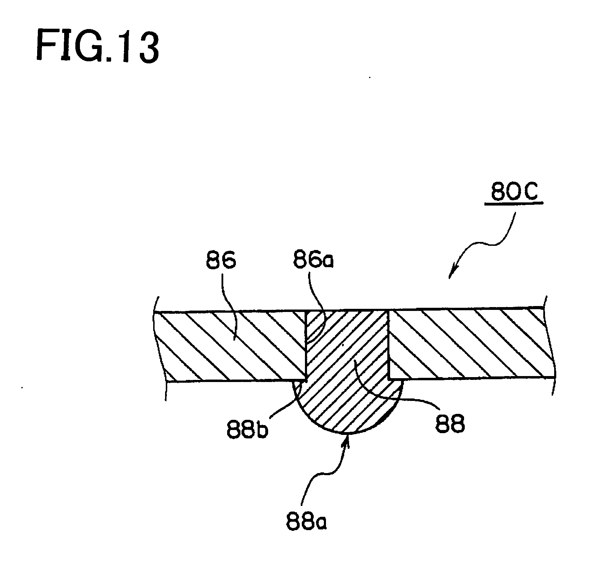

FIG. 8 is a perspective view of a calibration board according to a first embodiment of the present invention seen from the surface of the side facing the socket, FIG. 9 is a cross-sectional view along the line IX-IX of FIG. 8, FIG. 10 is a plan view showing a plurality of calibration boards held on a frame, FIG. 11 is a view showing the state of using a calibration board according to a first embodiment of the present invention to calibrate an electronic device test apparatus, FIG. 12 is a cross-sectional view of a calibration board according to a second embodiment of the present invention, and FIG. 13 is a cross-sectional view showing a calibration board according to a third embodiment of the present invention.

The calibration board according to a first embodiment of the present invention 80A is a board mounted on a socket 50 when calibrating the above explained electronic device test apparatus 1, that is, a board used for so-called HI-CAL. This calibration board 80A, as shown in FIG. 8 and FIG. 9, comprises a plurality of calibration terminals 81 electrically contacting contact terminals 70 of socket 50 and a board86 on which saidpluralityof calibration terminals 81 are provided. The plurality of calibration terminals 81 are arranged at the board 86 so as to correspond to the array of through holes 62 formed in the housing 60 of the socket 50. Note that FIG. 8 is a perspective view of the calibration board 80A seen from the rear surface. At the time of actual calibration, the calibration board 80 is inverted from the state shown in FIG. 8 and the spherical members 85 of the calibration terminals 81 are made to face the socket 50.

Each calibration terminal 81, as shown in FIG. 9, comprises an upper surface pad 82 formed from gold plating formed on an upper surface of the board 86, a lower surface pad 83 formed from gold plating formed on the lower surface of the board 86, a through hole 84 provided so as to pass through the board 86 and electrically connecting the upper surface pad 82 and lower surface pad 83, and a spherical member 85 bonded to the lower surface pad 83.

The spherical member 85 has a semispherical shape, is bonded to the lower surface pad 83, and sticks out from the board 86 toward the contact terminal 7 side. This spherical member 85 has a diameter smaller than the diameter of the opening part of the through hole 62 formed in the housing of the socket 50. When the calibration board 80A is mounted on a socket 50, the spherical member 85 enters the through hole 62 and can contact the contact terminal 70 of the socket 50 at the side part 85a.

This spherical member 85 comprises a semispherical electroconductive member made of a metal material etc. as its core and is plated with gold on its outer circumference. By the spherical member 85 contacting a contact terminal 70, the calibration terminal 81 of the calibration board 80A and the socket 50 are electrically connected. This spherical member 85 is mounted on a lower surface pad 83 by coating the lower surface pad 83 with a solder paste, placing a spherical member 85 on top of this, then heating it to make the solder paste melt. Note that the spherical member 85 and the lower surface pad 83 may also be connected using a conductive adhesive.

In a calibration board 80B according to a second embodiment of the present invention, as shown in FIG. 12, the calibration terminal 81 may be formed by a single pin 87. This pin 87 has a front end part 87a of a curved surface shape. This pin 87 is made of a metal material or other conductive material and plated with gold on its surface.

This pin 87 is press fit from the above into an insertion hole 86a formed in the board 86. A step part 87b formed at a rear end of the pin 87 is engaged with the peripheral edge of the top side opening part of the insertion hole 86a. The front end 87a of this pin 87 sticks out from the board 86 toward the contact terminal 70 side.

In a calibration board 80C according to a third embodiment of the present invention, as shown in FIG. 13, the calibration terminal 81 may be formed by a single pin 88 having a front end part 88a of a curved surface shape. In the present embodiment, this pin 88 is press fit from the bottom into the insertion hole 86a formed in the board 86. A step part 88b formed at a rear end of the curved surface front end part 88a is engaged with the peripheral edge of the bottom side opening part of the insertion hole 86a. The front end part 88a of this pin 88 also sticks out from the board 86 toward the contact terminal 70 side.

Returning to FIG. 8 and FIG. 9, the board 86 is made of a plastic material or other insulating material. For this reason, a plurality of calibration terminals 82 provided in a predetermined array at the board 86 are electrically insulated by the board 86 positioned between them. As the plastic material forming the board 86, for example a glass epoxy resin etc. may be mentioned.

The above configured calibration boards 80A, as shown in FIG. 10, are independently fastened and held in a frame 90. In the present embodiment, a number of calibration boards 80A corresponding to the number of simultaneous measurements (in present embodiment,32 arranged in four rows and eight columns) are held in the frame 90 so as to correspond to the sockets 50 mounted on the socket board 40. Due to said frame 90, 32 calibration boards 80A can be mounted on the sockets 50 at one time. Further, a dedicated CAL robot performing the calibration is used to perform measurements for a plurality of contact terminals 70.

When using a calibration board 80 A according to this embodiment to calibrate the electronic device test apparatus 1, as shown by the conceptual view shown in FIG. 11, first, the calibration board 80A is placed on a socket 50. At this time, the spherical members 85 of the calibration terminals 81 enter the through holes 62 of the housing 60, then said spherical members 85 push the curved surface parts 74 of the contact terminals 70 so that the elastic parts 73 make the curved surface parts 74 move in accordance with said pushing force and the side parts 85a of the spherical members 85 slide over and contact the curved surface parts 74. Due to this contact, the calibration terminals 81 of the calibration board 80A and the contact terminals 70 of the socket 50 are electrically connected.

After the calibration terminals 81 and the contact terminals 70 are electrically connected, as shown in FIG. 11, a probe 210 is made to abut against the upper surface pad 82 of the calibration board 80, the signal output to the waveform measuring apparatus (for example oscilloscope 200) connected to said probe 210 is monitored, and adjustments are made so that a predetermined test precision is secured, whereby the electronic device test apparatus 1 is calibrated. Note that usually this is automatically executed by a CAL robot. Due to this, accurate calibration of the timing at the positions of the curved surface parts 74 of the contact terminals 70 and inspection of the waveform quality are performed.

In the above way, in the present embodiment, by making the front ends of the calibration terminals 81 of a calibration board 80A stick out from the board 86, it becomes possible to calibrate an electronic device test apparatus 1 having sockets 50 of a type where the contact terminals 70 are recessed in the housing 60.

Further, by making the front ends of the calibration terminals 81 curved surface shapes, when the calibration terminals 81 and the contact terminals 70 contact, the side parts 85 of the spherical members 85 slide over the curved surface parts 74, any solder transferred to the contact terminals 70 canbe shavedoff, and the calibration terminals 81 and the contact terminals 70 can be stably connected.

Note that the calibration board 80A according to the present embodiment may also be applied for calibration of an electronic device test apparatus having sockets of types where the contact terminals are not recessed in the housing 60 (for example, usual pogo pin types). In this case as well, it is possible to shave off the solder transferred to the front ends of the pogo pins.

Note that the above explained embodiments were described to facilitate understanding of the present invention and were not described to limit the present invention. Therefore, the elements disclosed in the above embodiments include all design modifications and equivalents falling under the technical scope of the present invention.

## Claims

1. A calibration board mounted on a socket when calibrating an electronic device test apparatus for testing an electronic device under test by bringing input/output terminals of the electronic device under test into electrical contact with contact terminals of the socket, comprising:
calibration terminals for electrically contacting said contact terminals; and
a board comprising an insulating member and provided with the calibration terminals, wherein
the calibration terminals have projections sticking out from the board toward the contact terminal sides so as to correspond to the shapes of the contact terminals.

2. The calibration board as set forth in claim 1, wherein the projections of the calibration terminals have curved surface shapes.

3. A calibration board mounted on contact terminals of a socket when calibrating an electronic device test apparatus for testing an electronic device under test by bringing input/output terminals of the electronic device under test into electrical contact with the contact terminals, comprising:
calibration terminals electrically contacting said contact terminals; and
a board comprising an insulating member and provided with the calibration terminals, wherein
the calibration terminals have projections sticking out from the board toward the contact terminal sides in a curved surface shape.

4. The calibration board as set forth in any one of claims 1 to 3, wherein a plurality of the calibration terminals are provided on the board in substantially the same array as an array of the contact terminals of the socket.

5. The calibration board as set forth in any one of claims 1 to 4, wherein the projections are conductive spherical members bonded to pads provided on the board.

6. The calibration board as set forth in any one of claims 1 to 4, wherein
the calibration terminals are conductive pins provided so as to pass through the board and
the projections are curved surface parts formed at the front ends of the pins and sticking out from the board toward the contact terminals.
